Europäisches Patentamt

European Patent Office

Office européen des brevets

(11) Numéro de publication: **0 359 886**
**A1**

## (12) DEMANDE DE BREVET EUROPEEN

(21) Numéro de dépôt: 88402393.8

(22) Date de dépôt: 22.09.88

(51) Int. Cl.⁵: **G01R 15/02**

(43) Date de publication de la demande:
28.03.90 Bulletin 90/13

(84) Etats contractants désignés:
CH DE ES GB IT LI SE

(71) Demandeur: **Bruni, Olivier**
**55 rue Jean-Jaurès**
**F-92170 Vanves(FR)**

(72) Inventeur: **Bruni, Olivier**
**55 rue Jean-Jaurès**
**F-92170 Vanves(FR)**

(74) Mandataire: **Polus, Camille et al**
**c/o Cabinet Lavoix 2, Place d'Estienne**
**d'Orves**
**F-75441 Paris Cedex 09(FR)**

(54) Dispositif de mesure de courants forts.

(57) Ce dispositif comportant au moins un corps principal (1), traversé par le courant (I) à mesurer, et comprenant deux portions primaires (2,3) disposées de part et d'autre d'un axe de symétrie (X-X') du corps, chacune desdites portions présentant une première résistance, et une portion secondaire (4) disposée sur l'axe de symétrie du corps (1) et présentant une seconde résistance (R2) supérieure à la première résistance, ladite portion secondaire (4) étant connectée électriquement en parallèle sur lesdites portions primaires (2,3), et des moyens (5) associés à ladite portion secondaire (4) pour transformer l'amplitude du courant circulant dans cette portion secondaire (4) et fournir un courant de sortie en relation avec le courant circulant dans le corps, dans le rapport de la seconde résistance à la première résistance, est caractérisé en ce que les moyens associés à la portion secondaire (4) comprennent au moins un premier tore (6) présentant au moins un entrefer (6a), placé dans le plan de champ nul du corps, une cellule de mesure (7) à effet Hall étant disposée dans l'entrefer et reliée à un amplificateur de sortie (8) pour fournir un courant de sortie image du courant circulant dans le corps.

FIG.1

## Dispositif de mesure de courants forts.

La présente invention concerne un dispositif de mesure de courants forts.

On connait déjà dans l'état de la technique un certain nombre de dispositifs de ce type destinés à la mesure de courants continus à l'aide d'une cellule à effet Hall et qui utilisent essentiellement un conducteur parcouru par le courant I à mesurer. Ce conducteur constitue le circuit primaire d'un transformateur de mesure, généralement torique, traversé en son centre par le conducteur dans lequel circule le courant I et comportant au moins un entrefer dans lequel est placée une cellule à effet Hall sensible au champ créé par le courant I, un amplificateur opérationnel recevant sur ses entrées la tension délivrée par la cellule à effet Hall. Cet amplificateur fournit à sa sortie, un signal électrique qui est injecté dans un enroulement de compensation en fil fin bobiné sur le tore. Le courant de compensation a une valeur et un sens tels qu'il induit dans le tore un flux opposé et égal à celui créé par le passage du courant I dans le circuit primaire. Le courant de compensation est, selon un rapport de transformation donné, l'image du courant I à mesurer.

Pour des courants d'amplitudes relativement élevées, par example à partir de quelques milliers d'ampères, les dimensions du tore, dont le diamètre intérieur doit permettre le passage du conducteur dans lequel circule le courant I, deviennent très importantes, la section de ce conducteur étant croissante en fonction de la valeur de I. On est alors contraint d'utiliser des tores encombrants, lourds et onéreux avec les inconvénients que cela présente.

Afin de pallier à ces inconvénients, il est nécessaire d'avoir recours à des dispositifs de dérivation de courant, permettant de prélever une partie du courant I à mesurer, et donc de traiter un courant plus faible, dont l'amplitude est dans un rapport choisi avec celle du courant I à mesurer. Cette disposition permet d'utiliser, pour le traitement de la fraction de courant prélevée, des moyens magnétiques et/ou électroniques de puissance réduite. Le principe de la dérivation est déjà utilisé dans de multiples applications. Il se présente généralement sous la forme de deux conducteurs parallèles, l'un de grande section, traversé par la plus grande partie du courant I à mesurer, et l'autre de section notablement plus faible, dans lequel circule un courant très inférieur à I, et qui est une fraction de celui-ci sur laquelle on peut effectuer facilement la mesure.

Cependant, l'inconvénient de tels systèmes réside dans les effets parasites créés par le champ magnétique dû à la partie non dérivée du courant qui vient perturber, à partir des niveaux relativement bas, les moyens de mesure disposés sur la partie dérivée. De nombreux essais one montré que l'utilisation de blindages ou d'écrans magnétiques pour bloquer ces parasites, ne donnait pas de résultats satisfaisants.

On peut également avoir recours à des dispositifs tels que celui décrit dans le brevet US. 4 492 919 dans lequel le circuit de dérivation se présente sous la forme d'un conducteur de section réduite sur lequel sont disposés des moyens de mesure et disposé dans le même plan que deux autres conducteurs identiques connectés en parallèle avec le premier, mais de section beaucoup plus importante et disposés de part et d'autre d'un axe de symétrie, sur lequel est placé de conducteur de plus faible section.

Il est précisé dans le brevet précité, que la fraction de courant dérivée traverse un conducteur constituant le primaire d'un transformateur torique, dont le secondaire bobiné sur le tore fournit un courant alternatif image du courant I à mesurer.

Tel que défini, ce système ne permet donc pas la mesure de courants continus ni celle de courants alternatifs de fréquence variable, et à fortiori de courants impulsionnels. Par ailleurs, lors de l'utilisation d'un tore avec au moins un entrefer, ce dispositif est pertubé par les champs magnétiques générés par les deux conducteurs principaux.

Le but de l'invention est donc de résoudre ces problèmes en proposant un dispositif de mesure qui soit simple, faible et d'un prix de revient peu élevé et qui permette :

1) une mesure de courants continus de grande amplitude, de quelques centaines d'ampères à quelques dizaines de milliers d'ampères, tout en assurant une protection de la mesure notamment contre les influences magnétiques perturbatrices générées par les courants circulant dans les deux conducteurs principaux;

2) une isolation galvanique élévée entre un circuit primaire où circule le courant I à mesurer et un circuit secondaire délivrant un courant Is, image du courant I à mesurer, ce courant Is étant exploité par des dispositifs de mesure électroniques à isolement basse tension;

3) l'extension des propriétés de ce dispositif de mesure de courant, à la mesure de courants alternatifs de fréquence variable ou à la mesure de courants impulsionnels à fronts raides avec conservation de la phase du courant Is par rapport à celle du courant I, et

4) une miniaturisation du dispositif avec pour conséquence une réduction des coûts par rapport à des dispositifs existants ayant des performances comparables.

A cet effet, l'invention a pour objet un dispositif de mesure de courants forts, du type comportant au moins un corps principal, traversé par le courant à mesurer, et comprenant deux portions primaires disposée de part et d'autre d'un axe de symétrie dudit corps, chacune desdites portions présentant une première résistance, et une portion secondaire disposée sur l'axe de symétrie dudit corps et présentant une seconde résistance supérieure à ladite première résistance, ladite portion secondaire étant connectée électriquement en parallèle sur lesdites portions primaires, et des moyens associés à ladite portion secondaire pour transformer l'amplitude du courant circulant dans cette portion secondaire et fournir un courant de sortie du dispositif de mesure en relation avec le courant circulant dans le corps dans le rapport de la seconde résistance à la première résistance, caractérisé en ce que les moyens associés à la portion secondaire comprennent au moins un premier tore présentant au moins un entrefer, placé dans le plan de champ nul du corps, une cellule de mesure à effet Hall étant disposée dans ledit au moins un entrefer et reliée à un amplificateur de sortie pour fournir un courant de sortie image du courant circulant dans le corps.

Avantageusement, des moyens de compensation du déphasage entre le courant à mesurer et le courant de sortie du dispositif sont associés à la portion secondaire du corps.

L'invention sera mieux comprise à l'aide de la description qui va suivre, donnée uniquement à titre d'exemple et faite en se référant aux dessins annexés, sur lesquels :

- la Fig.1 représente une vue en perspective d'un premier mode de réalisation d'un dispositif selon l'invention;

- la Fig.2 représente une vue en coupe suivant la ligne A-A de la Fig.1;

- la Fig.3 représente une vue en perspective d'un second mode de réalisation d'un dispositif de mesure selon l'invention;

- les Fig.4,5,6 et 7 illustrent le fonctionnement de la compensation mise en oeuvre dans un dispositif selon l'invention;

- la Fig.8 représente une vue en perspective d'un mode de réalisation d'un corps entrant dans la constitution d'un dispositif selon l'invention;

- la Fig.9 représente une vue en coupe suivant la ligne B-B de la Fig.8; et

- la Fig.10 représente une vue en perspective d'un autre mode de réalisation d'un corps entrant dans la constitution d'un dispositif selon l'invention.

Le dispositif selon l'invention utilise d'un part, le principe d'une détection par cellule à effet Hall basée sur la production d'un champ magnétique dans l'entrefer d'un tore de mesure, créé par un courant primaire, et annulé dans le circuit magnétique du tore par un champ opposé, créé par un enroulement secondaire alimenté par un amplificateur délivrant un courant fonction du courant primaire, un tel principe étant exposé dans le brevet FR.2 151 998 et d'autre part un dispositif de mesure à dérivation, tel que celui décrit dans le brevet US 4 492 919, comme on le verra par la suite.

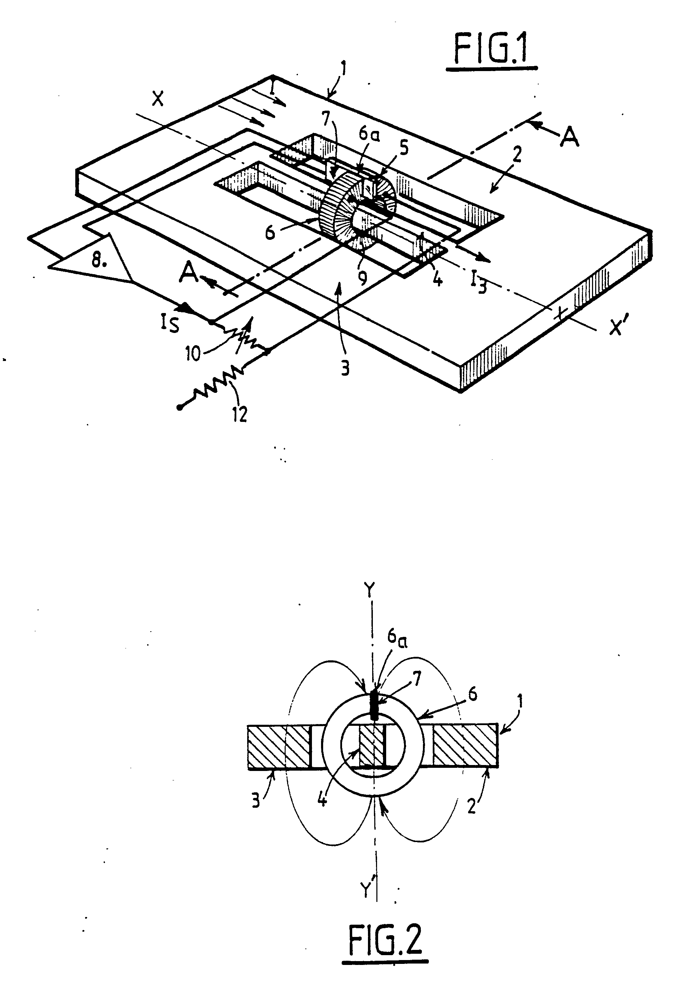

Ainsi qu'on peut le voir sur la Fig.1, un dispositif de mesure selon l'invention comporte un corps principal 1 en matériau conducteur, traversé par un courant I à mesurer, ce corps comprenant deux portions primaires 2 et 3 disposées de part et d'autre d'un axe de symétrie X-X' dudit corps. Chacune des portions primaires présente une première résistance R1. Le corps 1 comporte également une portion secondaire 4 disposée sur l'axe de symétrie X-X' du corps et présentant une seconde résistance R2 supérieure à ladite première résistance des portions primaires 2 et 3. Cette portion secondaire 4 est connectée électriquement en parallèle sur les portions primaires 2 et 3. Par ailleurs, des moyens 5 sont associés à ladite portion secondaire 4 pour transformer l'amplitude du courant circulant dans cette portion secondaire et fournir un courant de sortie du dispositif de mesure, en relation avec le courant circulant dans le corps, dans le rapport de la seconde résistance à la première résistance.

Comme on peut le voir sur les Fig.1 et 2, ces moyens 5 comprennent au moins un premier tore 6 présentant au moins un entrefer 6a placé dans le plan Y-Y' (Fig.2) de symétrie du corps et donc le champ nul de celui-ci. Une cellule de mesure à effet Hall 7 est disposée dans ledit entrefer 6a, donc dans le plan de champ nul du corps, et ses sorties sont reliées à un amplificateur 8 (Fig.1). La sortie de cet amplificateur est reliée à un enroulement 9 bobiné autour du tore 6 comme cela est connu en soi et une résistance d'étalonnage 10 peut être prévue en parallèle sur cet enroulement. La fonction de cette résistance sera décrite plus en détail par la suite.

L'amplificateur 8 est ainsi alimenté par une tension délivrée par la cellule à effet Hall 7, cette tension étant proportionnelle à un courant $I_3$ circulant dans la portion secondaire 4 du corps, et image du courant I à mesurer circulant dans le corps, selon la relation définie ci-dessous.

$$I_3 = \frac{I}{2\,\frac{R2}{R1} + 1}$$

Par ailleurs, l'amplificateur 8 réinjecte dans l'enroulement 9 un courant Is (en supposant la résistance d'étalonnage 10 supprimée) produisant des ampéres-tours opposés à ceux créés par le courant primaire $I_3$ tel que le champ résultant dans l'entrefer du tore soit nul.

On a donc également :

$I_3$ = NIs

où N représente le nombre de spires de l'enroulement 9.

Ceci permet de déterminer I à partir de Is. Ainsi, l'utilisation d'un système à dérivation et de cellules à effet Hall permet d'obtenir un très grand rapport de transformation entre le courant I à mesurer et le courant de sortie Is, ce qui permet de réduire les moyens de traitement de ce signal.

Cependant, il est à noter que pour des mesures de précision, les relations définies ci-dessus ne sont applicables qu'en régime établi pour des courants continus ou des courans alternatifs à fréquence constante. Les applications en régime transitoire nécessitent une adaptation des constantes de temps L/R entre les portions primaires 2 et 3 et la portion secondaire 4.

En effet, en régime transitoire, la proportion $I_3$ de courant dérivée dans la portion secondaire 4 par rapport au courant total I, n'est plus fonction du rapport des résistances des portions du corps, mais du rapport des impédances des portions primaires 2 et 3 et de la portion secondaire 4.

Pour que le rapport des impédances coincide indépendamment de la variation en fonction du temps du courant I à mesurer avec le rapport des résistances, il faut égaler les constantes de temps L/R des différentes portions 2,3 et 4.

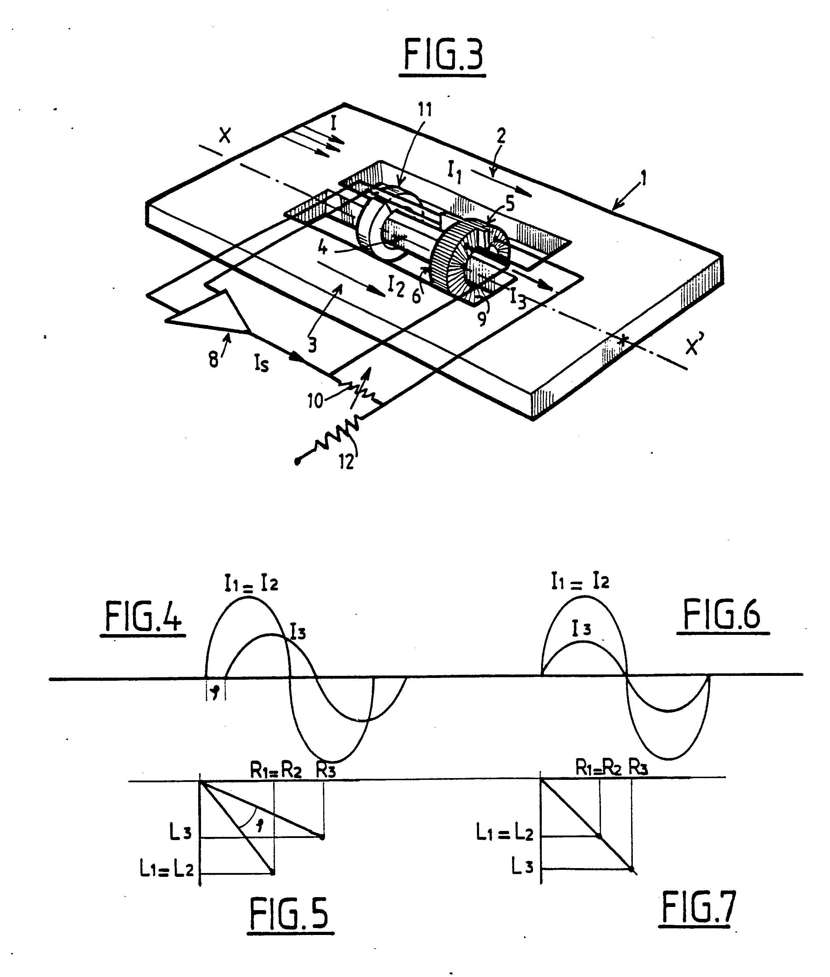

C'est ainsi que des moyens 11 (Fig.3) de compensation du déphasage entre le courant à mesurer et le courant de sortie du dispositif sont associés à la portion secondaire 4 du corps. Ces moyens de compensation sont par exemple constitués par un second tore magnétique disposé autour de cette portion secondaire 4 et présentant par exemple deux entrefers disposés dans le plan de champ nul du corps. Ce tore magnétique doit être non saturable sur l'étendue de la plage du courant à mesurer. Cette compensation des rapports L/R a également pour conséquence de remettre en phase les courants I1,I2 et I3 par rapport au courant total I, comme on peut le voir sur les Fig.4,5,6 et 7, I1 et I2 étant les courants circulant dans les portions 2 et 3 du corps.

Ceci permet d'obtenir un courant Is image du courant I à mesurer, en phase avec ce courant I, que la mesure soit effectuée sur des courants continus variables dans le temps, alternatifs ou impulsionnels.

Malgré toutes les précautions d'usinage qui peuvent être prises pour réaliser le corps 1, il peut être nécessaire d'avoir recours à un étalonnage du dispositif afin d'obtenir une grande précision du rapport choisi entre le courant I à mesurer et le courant Is image de celui-ci.

Le procédé d'étalonnage du dispositif selon l'invention est donc mis en oeuvre par l'intermédiaire de la résistance 10 connectée en parallèle aux bornes de l'enroulement 9 bobiné autour du tour 6 et qui per-met de faire varier la valeur du courant traversant une résistance de mesure 12. Cependant, pour ce mode d'étalonnage, il est nécessaire de prévoir une section de la portion secondaire 4 par rapport à celles des sections primaires 2 et 3, telles que le rapport de transformation soit supérieur à celui choisi effectivement afin de permettre le réglage.

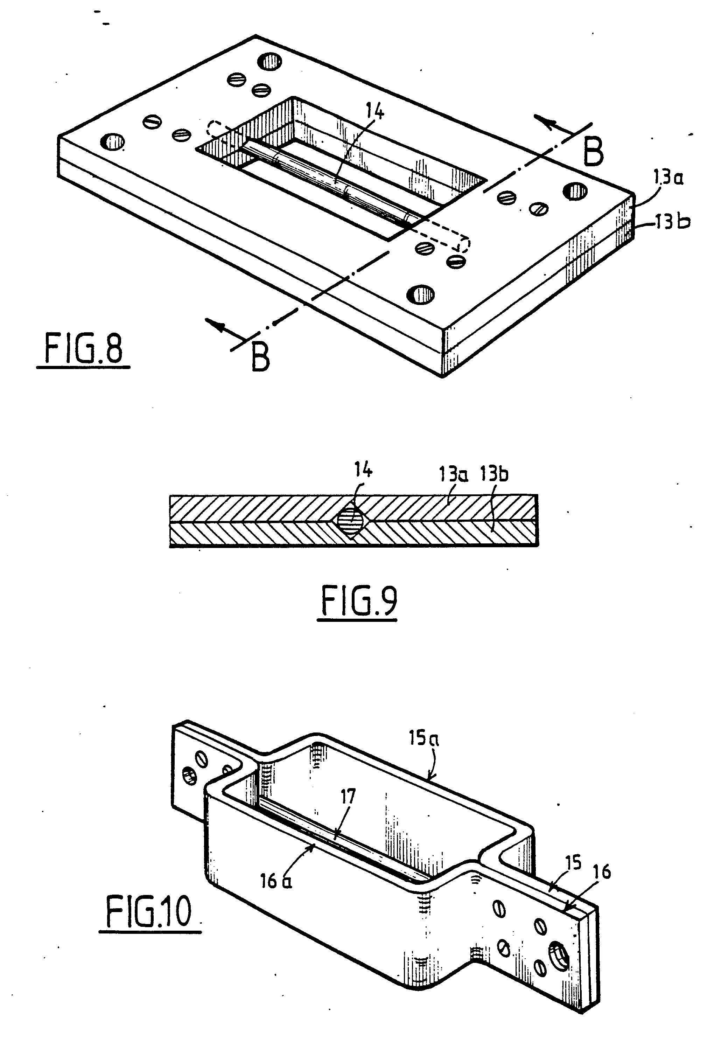

Comme on peut le voir sur les Fig.8,9 ou 10 qui représentent différentes variantes de réalisation d'un corps entrant dans la constitution du dispositif selon l'invention, celui-ci peut se présenter sous la forme de deux plaques 13a, 13b (Fig.8 et 9), plates et indentiques et comportant un évidement central délimitant les portions primaires. Ces plaques sont fixées l'une sur l'autre par tout moyen connu en soi, comme par exemple des boulons et une tige 14 constituant la portion secondaire du corps est bloquée entre celles-ci et traverse l'évidement central. Le corps est ainsi rendu entièrement démontable afin de permettre :

- une introduction aisée des moyens de mesure et de compensation sur la tige 14;
- une standardisation des éléments constituant le corps quel que soit le rapport I/Is, ce rapport étant obtenu comme mentionné précédemment, par la variation des dimensions des portions primaires par rapport à la dimension de la portion secondaire du corps; et
- une réalisation aisée du moulage assurant un isolement galvanique élevé entre le primaire et le secondaire du dispositif.

Dans le mode de réalisation représenté sur la Fig.10, les deux plaques 15 et 16 entrant dans la constitution du corps comprennent des décrochements 15a et 16a, disposés symétriquement de part et d'autre d'une tige 17 constituant la portion secondaire du corps.

Il est également à noter que le dispositif de mesure selon l'invention peut nécessiter, dans le cas d'un environnement créateur de champs magnétiques importants, d'avoir recours à une enveloppe connue en soi protégeant l'ensemble du dispositif contre les effets perturbateurs de ces champs magnétiques.

Par ailleurs, une précaution supplémentaire contre ces effets perturbateurs peut être utilisée en disposant une deuxième cellule à effet Hall symétriquement par rapport à la première dans le plan de champ nul du corps.

Enfin, le dispositif selon l'invention peut également fonctionner en différentiel de courant, en utilisant deux corps identiques placés l'un au-dessus de l'autre, et isolés l'un de l'autre, le premier tore étant disposé autour des portions secondaires de ceux-ci, ainsi que le tore de compensation. Pour obtenir une mesure différentielle, les courants principaux qui traversent ces deux corps sont opposés.

## Revendications

1. Dispositif de mesure de courants forts, du type comportant au moins un corps principal (1) traversé par le courant (I) à mesurer, et comprenant deux portions primaires (2,3) disposées de part et d'autre d'un axe de symétrie (X-X') dudit corps, chacune desdites portions présentant une première résistance (R1), et une portion secondaire (4) disposée sur l'axe de symétrie dudit corps (1) et présentant une seconde résistance (R2) supérieure à ladite première résistance, ladite portion secondaire (4) étant connectée électriquement en parallèle sur lesdites portions primaires (2,3) et des moyens (5) associés à ladite portion secondaire (4) pour transformer l'amplitude du courant circulant dans cette portion secondaire (4) et fournir un courant de sortie du dispositif de mesure en relation avec le courant circulant dans le corps dans le rapport de la seconde résistance à la première résistance, caractérisé en ce que les moyens associés à la portion secondaire (4) comprennent au moins un premier tore (6) présentant au moins un entrefer (6a), placé dans le plan de champ nul (Y-Y') du corps, une cellule de mesure (7) à effet Hall étant disposée dans ledit au moins un entrefer et reliée à un amplificateur de sortie (8) pour fournir un courant de sortie image du courant circulant dans le corps.

2. Dispositif selon la revendication 1, caractérisé en ce que des moyens de compensation (11) du déphasage entre le courant (I) à mesurer et le courant de sortie (Is) du dispositif, sont associés à la portion secondaire (4) du corps (1).

3. Dispositif selon la revendication 2, caractérisé en ce que les moyens de compensation (11) comprennent un second tore magnétique disposé autour de la portion secondaire (4) du corps et présentant deux entrefers également disposés dans le plan de champ nul (Y-Y') du corps.

4. Dispositifs selon l'une quelconque des revendications précédentes, caractérisé en ce que la sortie de l'amplificateur (8) est reliée à un enroulement (9) bobiné autour du premier tore (6) et en ce qu'une résistance d'étalonnage (10) est connectée en parallèle sur cet enroulement.

5. Dispositif selon l'une quelconque des revendications précédentes, caractérisé en ce que ledit corps comprend deux plaques identiques (13a, 13b; 15,16) fixées l'une sur l'autre et entre lesquelles est bloquée une tige (14;17) constituant la portion secondaire de celui-ci.

6. Dispositif selon l'une quelconque des revendications précédentes, caractérisé en ce que le premier tore présente deux entrefers placés dans le plan de champ nul (Y-Y') du corps et dans lesquels sont disposées deux cellules de détection à effet Hall.

## FIG.1

## FIG.2

FIG.3

FIG.4

FIG.6

FIG.5

FIG.7

FIG.8

FIG.9

FIG.10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 240 059 (J.E. WOLF et al.)<br>* revendications 1,3; figures 2,3 *<br>--- | 1 | G 01 R 15/02 |
| Y | EP-A-0 194 225 (LEM S.A.)<br>* pages 1,2, lignes 1-22; figures 1,2 * | 1 | |
| A | <br>--- | 2-4 | |
| Y | REVUE GENERALE DE L'ELECTRICITE<br>no. 5, mai 1984, pages 288-292, Paris,<br>FR; G. GAUTHIER:"2-Le capteur<br>d'intensité à effet Hall" * page 289,<br>paragraphe 2.2, page 290, paragraphe 3;<br>figures 8,9 *<br>--- | 1 | |
| A,D | US-A-4 492 919 (M. MILKOVIC)<br>* figure 2A *<br>--- | 1 | |
| A | DE-A-2 232 196 (ZELLWEGER)<br>* revendication 1, figures 1,2 *; & FR<br>- A - 21 51998 (Cat. A,D)<br>----- | | |

| | | | DOMAINES TECHNIQUES RECHERCHES (Int. Cl.4) |
|---|---|---|---|
| | | | G 01 R 15/00 |

Le présent rapport a été établi pour toutes les revendications

| Lieu de la recherche | Date d'achèvement de la recherche | Examinateur |
|---|---|---|
| BERLIN | 27-04-1989 | LEMMERICH J |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P0402)